# EUROPEAN PATENT APPLICATION

(11) **EP 2 466 652 A1**
(43) Date of publication of application: **20.06.2012**
(21) Application number: 10829322.6
(22) Date of filing: 09.12.2010
(51) Int. Cl.: H01L 33/00

(54) **LIGHT EMITTING DEVICE AND MANUFACTURING METHOD THEREOF**

(30) Priority: 29.09.2010 CN 201010503677
(71) Applicant: Enraytek Optoelectronics Co., Ltd., Shanghai 201203 (CN)
(72) Inventor: CHANG, Richard Rugin, Pudong New District, Shanghai 201203 (CN); XIAO, Deyuan, Pudong New District, Shanghai 201203 (CN)
(74) Representative: Hogeweg, Albertus Johan
(86) International application number: PCT/CN2010/079603
(87) International publication number: WO 2012/040978

(57) **Abstract**

The present invention provides a light emitting device, including a base, an LED inversely mounted on the base. The LED includes a buffer layer, an LED chip on the buffer layer. The buffer layer includes a plurality of protrusions with complementary pyramid structure on a light-exiting surface of the LED. The present invention also provides a method for manufacturing a light emitting device, including: providing a substrate and forming a plurality of pyramid structures on the substrate; forming successively a buffer layer, an n-type semiconductor layer, an active layer, a p-type semiconductor layer and a contact layer on the substrate with the pyramid structures; forming an opening with a depth at least from the contact layer to a top of the n-type semiconductor layer, and forming a first electrode on the contact layer and a second electrode on a bottom of the opening; and removing the substrate. The light emitting device has a high luminous efficiency and the manufacturing method is easy to implement.

## Description

The present application claims the priority of Chinese Patent Application No. 201010503677.9, entitled "Light Emitting Device and Manufacturing Method thereof", and filed September 29, 2010, the entire disclosure of which is incorporated herein by reference.

### FIELD OF INVENTION

The present invention relates to the semiconductor field, and particularly relates to a light emitting device and manufacturing method thereof.

### BACKGROUND OF THE INVENTION

A light emitting diode (LED) is a semiconductor device, which emits different colored light driven by current. Semiconductor material consisting of a compound of the III-V family such as gallium nitride (GaN) has attracted widespread attention because of its wide bandgap, high luminous efficiency, high saturated electron drift velocity, high chemical stability, and huge potential in high brightness blue LED, blue lasers and other optoelectronic fields.

However, conventional LED devices have a problem of low luminous efficiency, which are only several percentage points before LED packaging. Large amount of energy is wasted inside LED devices, causing both energy waste and shorter service life. Therefore, improving the luminous efficiency is very important for LED devices.

Based on the above requirements, many ways of improving the luminous efficiency of LED have been applied to the LED device structure, such as the surface roughening method, metal reflecting mirror structure, etc. In a Chinese patent application (publication number CN1858918A), an LED with an omnidirectional reflector structure to improve the luminous efficiency is disclosed. However, in the method, a film structure including stacked high refractive index layers and low refractive index layers is required to be formed on a substrate. Therefore, the manufacture process of the method is complex.

### SUMMARY OF THE INVENTION

It is an object of this invention to provide a light emitting device to improve luminous efficiency.

To achieve the above-mentioned object of the present invention, from the first aspect of the present invention, there is provided a light emitting device, including a base and an LED inversely mounted on the base. The LED includes a buffer layer and an LED chip on the buffer layer. The buffer layer includes a plurality of protrusions with complementary pyramid structure on a light-exiting surface of the LED.

From the second aspect of the present invention, there is provided a method for manufacturing a light emitting device, including: providing a substrate and forming a plurality of pyramid structures on the substrate; forming successively a buffer layer, an n-type semiconductor layer, an active layer, a p-type semiconductor layer and a contact layer on the substrate with the pyramid structures; forming an opening with a depth at least from the contact layer to a top of the n-type semiconductor layer, and forming a first electrode on the contact layer and a second electrode on a bottom of the opening; and removing the substrate.

In comparison with conventional technologies, the present invention has the following advantages:
1. The buffer layer includes a plurality of protrusions with complementary pyramid structure on a light-exiting surface of the LED. The protrusions increase the area of the light-exiting surface, thus improving the possibility for light emitted from the LED chip to reach the light-exiting surface and improving the luminous efficiency of the light emitting device.
2. The light emitting device further includes a contact layer and a reflecting film which reflect light to a light output direction of the light emitting device, thus further improving the luminous efficiency of the light emitting device.
3. The light emitting device further includes cap layer to converge light, which improves the brightness of the light emitting device.
4. The method for manufacturing a light emitting device includes: forming a plurality of pyramid structures on the substrate, filling small openings among the pyramid structures to form complementary pyramid structures, and inversely mounting the LED on the base, which is easy to implement.

### BRIEF DESCRIPTION OF THE DRAWINGS

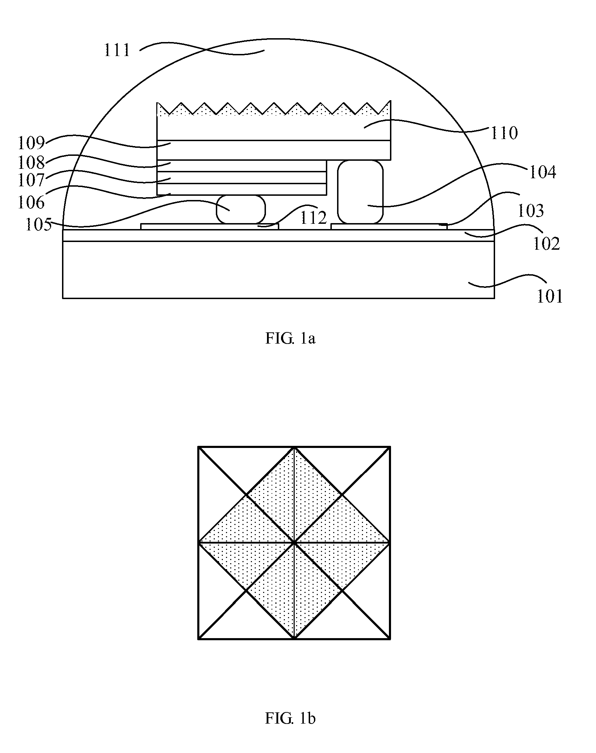

FIG. 1a is a sectional view of an embodiment of the light emitting device of the present invention;

FIG. Ibis a top view of complementary pyramid structures in FIG. 1a;

FIG. 2 is a flow diagram of an embodiment of the method for manufacturing a light emitting device in the present invention;

FIG. 3 is a flow diagram of an embodiment of the step S1 in FIG. 2;

FIG. 4 to FIG. 10b are sectional views of a light emitting device in an embodiment of the method for manufacturing a light emitting device.

### DESCRIPTION OF THE PREFERRED EMBODIMENTS

Hereunder, the present invention will be described in detail with reference to embodiments, in conjunction with the accompanying drawings.

Embodiments to which the present invention is applied are described in detail below. However, the invention is not restricted to the embodiments described below.

As described in the background, in conventional technology, to improve the luminous efficiency of LED, a film structure including stacked high refractive index layers and low refractive index layers is required to be formed on a substrate, which leads to a complex manufacture process.

To solve the above problem, the present invention provides a light emitting device, which includes an LED inversely mounted on the base. The LED includes a plurality of complementary pyramid structures on a light-exiting surface of the LED, which increases the area of the light-exiting surface and improves the possibility for light emitted from an active layer to reach the light-exiting surface, the external quantum efficiency of the LED, and the luminous efficiency of the LED.

Referring to FIG. 1a, a sectional view of an embodiment of the light emitting device of the present invention is illustrated. The light emitting device includes: a base 101, a reflecting film 102 on the base 101, a first lead 112 and a second lead 103 on the reflecting film 102, an LED inversely mounted on the first lead 112 and the second lead 103, a cap layer 111 covers the reflecting film 102 and the LED.

The base 101 is used to support the LED. In embodiments of the present invention, the base 101 is made from copper, aluminum, silicon, or aluminum nitride, etc.

The reflecting film 102 is used to reflect light emitted from the LED to the light output direction of the light emitting device, to improve the luminous efficiency of the light emitting device and increase the lightness of the light emitting device. Specifically, the material of reflecting film 102 is barium oxide.

The first lead 112 is used to connect the LED to the positive terminal of a power supply (not shown); the second lead 103 is used to connect the LED to the negative terminal of the power supply (not shown). Specifically, the first lead 112 and the second lead 103 are made from conductive materials such as copper or aluminum, etc.

The LED includes a buffer layer 110, an n-type semiconductor layer 109, an active layer 108, a p-type semiconductor layer 107, and a contact layer 106 successively from top to bottom.

The bottom of the buffer layer 110 includes a plurality of protrusions. The protrusions are of complementary pyramid structure (FIG. 1b is a top view of complementary pyramid structures). Specifically, the complementary pyramid structures are formed by filling the small openings among the pyramid structures. The protrusions with complementary pyramid structure increases the area of the light-exiting surface and improves the possibility for light emitted from an LED chip to reach the light-exiting surface and the luminous efficiency of the LED. Specifically, the buffer layer 110 is made from gallium nitride or aluminum nitride.

The n-type semiconductor layer 109, the active layer 108, and the p-type semiconductor layer 107 constitute an LED chip. In an embodiment of the present invention, the material of the n-type semiconductor layer 109 is n-type gallium nitride, and the active layer 108 is a multi-quantum well active layer. Specifically, the active layer 108 is made from InGaN, to produce blue light with wavelength of 470nm; the p-type semiconductor layer 107 is p-type gallium nitride.

The contact layer 106 is used to electrically connect the p-type semiconductor layer 107 to a positive terminal of a power supply. The area of the contact layer 106 is large to reduce contact resistance. Preferably, the lower surface of the contact layer 106 is a reflecting surface, which reflects light emitted from LED chip to the light-exiting surface. Specifically, the material of the contact layer 106 is gold or nickel, etc, and the thickness of the contact layer 106 is from 50 to 100 nm.

The LED further includes a first electrode 105 located between the contact layer 106 and the first lead 112, which is to electrically connect the p-type semiconductor layer 107 to the first lead 112.

The LED further includes an opening with a depth at least from the contact layer 106 to the n-type semiconductor layer 109. The LED further includes a second electrode 104 with one end connected to the bottom of the opening and the other end connected to the second lead 103. The second electrode 104 is used to electrically connect the n-type semiconductor layer 109 to the second lead 103.

The cap layer 111 covers the LED and the reflecting film 102. The cap layer 111 is provided with a lens structure in a light output direction of the LED. The lens structure converges light from LED, which improves the lightness of the light emitting device. In an embodiment, the cap layer 111 is made from materials such as colophony. The cap layer 111 can also protect the LED.

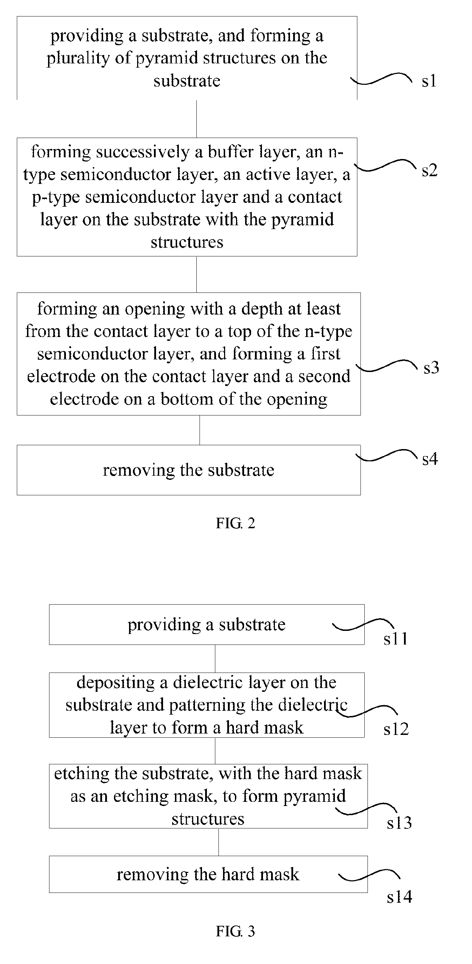

There is also provided a method for manufacturing a light emitting device in the present invention. Referring to FIG. 2, the method includes:
S1, providing a substrate, and forming a plurality of pyramid structures on the substrate;
S2, forming successively a buffer layer, an n-type semiconductor layer, an active layer,
a p-type semiconductor layer and a contact layer on the substrate with the pyramid structures;
S3, forming an opening with a depth at least from the contact layer to a top of the n-type semiconductor layer, and forming a first electrode on the contact layer and a second electrode on a bottom of the opening; and
S4, removing the substrate.

Referring to FIG. 3, step S1 in FIG. 2 further includes:
S11, providing a substrate;
S12, depositing a dielectric layer on the substrate and patterning the dielectric layer to form a hard mask;
S13, etching the substrate, with the hard mask as an etching mask, to form pyramid structures;
S14, removing the hard mask.

In the step S11, the substrate 201 is a p-type silicon substrate of (100) lattice plane. The silicon substrate has a resistivity of 1∼20 ohms-centimeters.

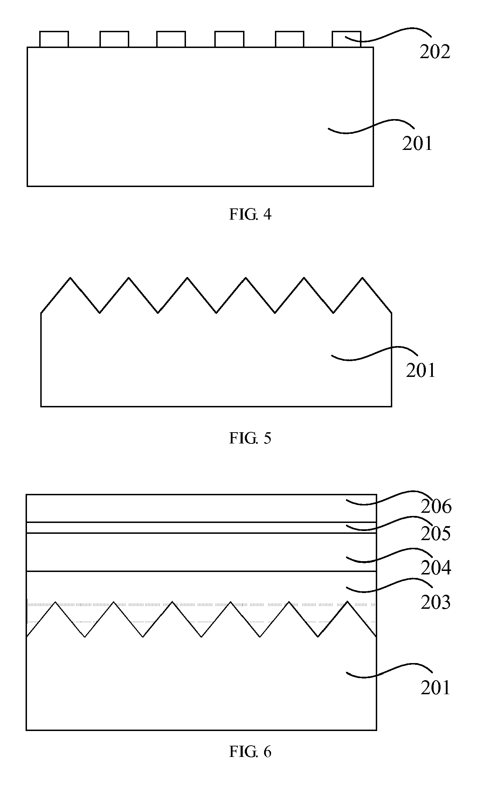

Referring to FIG. 4, in step S12, the dielectric layer is made from silicon dioxide. The hard mask 202 on the substrate 201 is formed by dry etching the dielectric layer.

Referring to FIG. 5, in steps S13 and S14, wet etching the substrate 201 with tetramethylammonium hydroxide (TMAH) to form pyramid structures with (111) lattice planes as side faces and (100) lattice planes as bottom faces on the silicon substrate. Specifically, the wet etching has an etching time of 20 minutes and an etching temperature of 60∼80°C. Specifically, the pyramid structures are arranged in matrix, the bottom plane in each pyramid structure is a square, and the side plane and bottom plane in each pyramid structure forms an angle of 54.74 °.

If the density of the pyramid structures is too large, the pyramid structures formed by etching are not high enough; and if the density of the pyramid structures is too small, the number of the pyramid structures is not enough, which can not increase the area of the light-exiting surface of the LED as required. The density of the pyramid structures is 4×104∼1×108 per square millimeter normally. The density of the pyramid structures can be controlled by the density of the hard mask in the manufacturing method, so as to form enough pyramid structures with proper dimensions. Preferably, each pyramid structure has a bottom square with a side length of 5µm, and a height of 3.53µm from the top to the bottom.

The hard mask 202 made from silicon dioxide is then removed with hydrofluoric acid solution, which forms the substrate 201 with pyramid structures.

Referring to FIG. 6, in step S2, the buffer layer 203, n-type semiconductor layer 204, active layer 205 and p-type semiconductor layer 206 are formed successively by Metal-organic Chemical Vapor Deposition (MOCVD).

In one embodiment, during depositing the buffer layer 203, small openings among the pyramid structures on the substrate 201 are filled first till the pyramid structures are covered, which forms a plurality of protrusions with complementary pyramid structure at the bottom of the buffer layer 203. The protrusions are formed in the small openings among the pyramid structures.

In this embodiment, the side faces of each pyramid structure are silicon of (111) lattice plane. The material of the buffer layer 203 is aluminium nitride or gallium nitride (GaN), which matches the lattice constant of silicon.

The buffer layer 203 fully covers the pyramid structure, and preferably, the buffer layer 203 has a thickness of 10∼100µm.

The n-type semiconductor layer 204 is n-type gallium nitride; the active layer 205 is a multi-quantum well active layer. Specifically, the active layer 205 is made from InGaN, to produce blue light with wavelength of 470nm; the p-type semiconductor layer 206 is p-type gallium nitride.

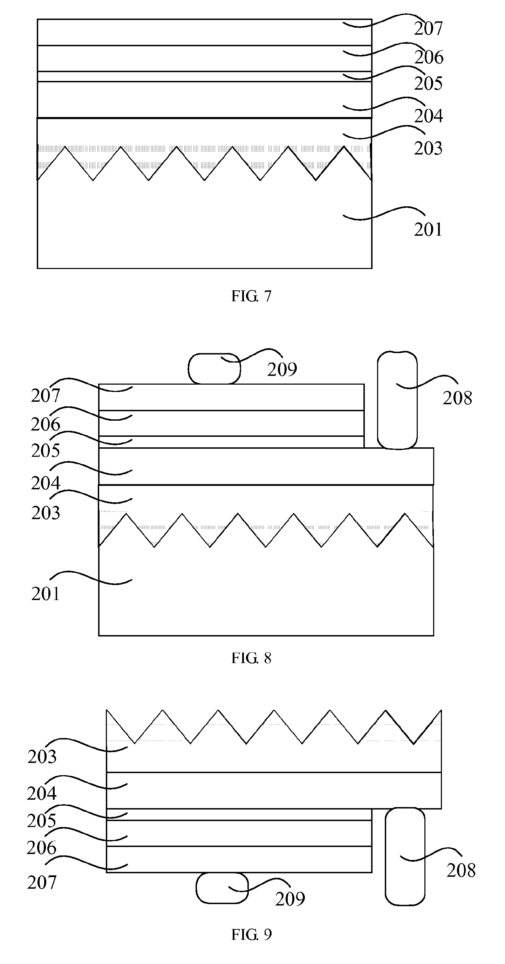

Referring to FIG. 7, a contact layer 207 is formed on the p-type semiconductor layer 206. Specifically, the contact layer 207 is made from metal material such as gold or nickel, etc. The contact layer 207 is formed by physical vapor deposition (PVD) or electron beam evaporation. The thickness of the contact layer 207 is from 50 to 100 nm.

Referring to FIG. 8, in step S3, an opening is formed by dry etching, which depth is at least from the contact layer 207 to the top of the n-type semiconductor layer 204. A first electrode 209 is formed on the contact layer 207 and a second electrode 208 is formed on the bottom of the opening. The upper surface of the first electrode 209 and the second electrode 208 are on a same level. Specifically, the first electrode 209 and the second electrode 208 are made from gold, aluminium or nickel.

Referring to FIG. 9, in step S4, the silicon substrate 201 is removed with potassium hydroxide solution. It should be noted that the silicon substrate 201 can be removed with other solutions which have high selection ratio to silicon to avoid removing other materials. The manufacture of LED is finished.

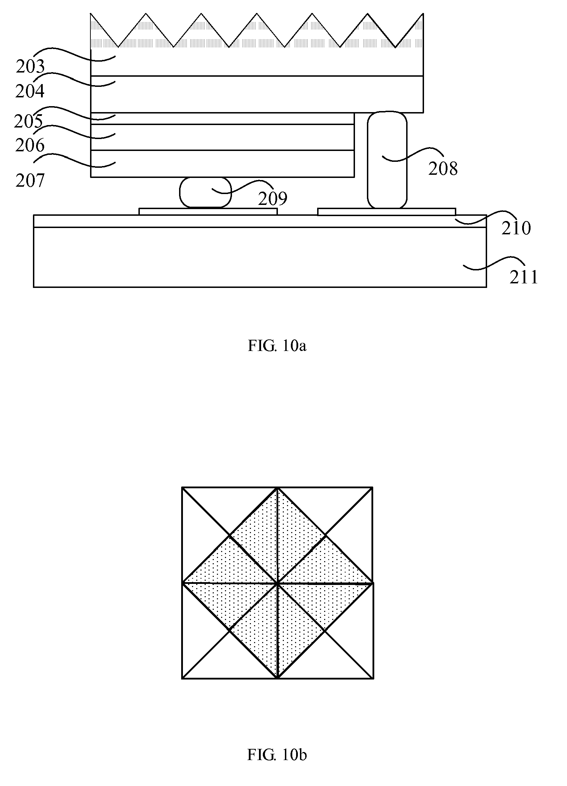

The method for manufacturing a light emitting device also includes steps of encapsulation. Referring to FIG. 10a and FIG. 10b (FIG. 10b is a top view of the complementary pyramid structures in FIG. 10a), the steps of encapsulation includes: providing a base 211, forming a reflecting film 210 on the base 211, and forming a first lead on the reflecting film 210 connected with the positive terminal of the power supply and a second lead on the reflecting film 210 connected with the negative terminal of the power supply. The LED is then inversely mounted on the reflecting film 210. Specifically, the LED is mounted on the reflecting film 210 in a way that the buffer layer 203 faces the light output direction, the first electrode 209 is fixed to the first lead and the second electrode 208 is fixed to the second lead.

The method for manufacturing a light emitting device also includes forming a cap layer (not shown) which covers the LED and the reflecting film 210. Preferably, the cap layer is provided with a lens structure in a light output direction of the LED. The lens structure converges light from LED. The cap layer is made from materials such as colophony.

The method for manufacturing a light emitting device is finished.

In conclusion, the present invention provides a light emitting device, including an LED with a light-exiting surface provided with protrusions with complementary pyramid structure. The protrusions with complementary pyramid structure increase the area of the light-exiting surface and improve the luminous efficiency of the light emitting device.

The light emitting device further includes a contact layer and a reflecting film which reflect light to a light output direction of the light emitting device, thus further improving the luminous efficiency of the light emitting device.

The light emitting device further includes cap layer to converge light, which improves the brightness of the light emitting device.

The method for manufacturing a light emitting device includes: forming a plurality of pyramid structures on the substrate, filling small openings among the pyramid structures to form complementary pyramid structures, and inversely mounting the LED on the base. The method is easy to implement.

Although the present invention has been illustrated and described with reference to the preferred embodiments of the present invention, those ordinary skilled in the art shall appreciate that various modifications in form and detail may be made without departing from the spirit and scope of the invention.

## Claims

1. A light emitting device **characterized by** comprising:
a base; and
an LED inversely mounted on the base, the LED including a buffer layer and an LED chip on the buffer layer, the buffer layer including a plurality of protrusions with complementary pyramid structure on a light-exiting surface of the LED.

2. The light emitting device of claim 1, **characterized in that** the LED chip includes an n-type semiconductor layer, an active layer and a p-type semiconductor layer which are successively located on the buffer layer.

3. The light emitting device of claim 2, **characterized in that** the LED further includes a contact layer on the LED chip.

4. The light emitting device of claim 3, **characterized in that** a surface of the contact layer between the contact layer and the LED chip is a reflecting surface which reflects light emitted from the LED chip to the light-exiting surface of the LED.

5. The light emitting device of claim 1, **characterized in that** the light emitting device further comprises a reflecting film on the base for reflecting light emitted from the LED chip to the light-exiting surface of the LED.

6. The light emitting device of claim 5, **characterized in that** the light emitting device further comprises a first lead and a second lead on the reflecting film, the first lead for connecting the LED to a positive terminal of a power supply, the second lead for connecting the LED to a negative terminal of the power supply.

7. The light emitting device of claim 6, **characterized in that** the LED further includes a contact layer on the LED chip, and a first electrode connecting the contact layer to the first lead; and
the LED further includes a second electrode, and an opening with a depth at least from the contact layer to a top of an n-type semiconductor layer, the second electrode connecting a bottom of the opening to the second lead.

8. The light emitting device of claim 6, **characterized in that** the light emitting device further comprises a cap layer which covers the reflecting film and the LED.

9. The light emitting device of claim 8, **characterized in that** the cap layer is provided with a lens structure in a light output direction of the LED.

10. A method for manufacturing a light emitting device **characterized by** comprising:
providing a substrate and forming a plurality of pyramid structures on the substrate;
forming successively a buffer layer, an n-type semiconductor layer, an active layer, a p-type semiconductor layer and a contact layer on the substrate with the pyramid structures;
forming an opening with a depth at least from the contact layer to a top of the n-type semiconductor layer, and forming a first electrode on the contact layer and a second electrode on a bottom of the opening; and
removing the substrate.

11. The method for manufacturing a light emitting device of claim 10, **characterized in that** the providing a substrate and forming a plurality of pyramid structures on the substrate includes:
providing a substrate;
depositing a dielectric layer on the substrate and patterning the dielectric layer to form a hard mask;
etching the substrate, with the hard mask as an etching mask, to form pyramid structures;
removing the hard mask.

12. The method for manufacturing a light emitting device of claim 11, **characterized in that** the substrate is a p-type silicon substrate of (100) lattice plane;
the etching the substrate with the hard mask as an etching mask to form pyramid structures includes: wet etching the substrate with tetramethylammonium hydroxide solution to form pyramid structures which include (111) lattice planes of the silicon substrate as side faces and (100) lattice planes of the silicon substrate as bottom faces; and
the buffer layer is formed on the (111) lattice planes.

13. The method for manufacturing a light emitting device of claim 12, **characterized in that** in a step of the wet etching the substrate with tetramethylammonium hydroxide solution, the step has an etching time of 20 minutes and an etching temperature of 60∼80 degrees Celsius.

14. The method for manufacturing a light emitting device of claim 12, **characterized in that** in each of the pyramid structures which include (111) lattice planes of the silicon substrate as side faces and (100) lattice planes of the silicon substrate as bottom faces, a side face and a bottom face forms an angle of 54.74 °.

15. The method for manufacturing a light emitting device of claim 12, **characterized in that** a density of the pyramid structures on the substrate is 4×104∼1 × 10⁸ per square millimeter.

16. The method for manufacturing a light emitting device of claim 12, **characterized in that** the silicon substrate is removed with potassium hydroxide solution.

17. The method for manufacturing a light emitting device of claim 10, **characterized in that** an upper surface of the first electrode on the contact layer and an upper surface of the second electrode on the bottom of the opening are on a same level.

18. The method for manufacturing a light emitting device of claim 10, **characterized by** further comprising:
providing a base, forming a reflecting film on the base, and forming on the reflecting film a first lead connected to a positive terminal of a power supply and a second lead connected to a negative terminal of the power supply; and
mounting the LED on the reflecting film in a way that the buffer layer faces the light output direction, the first electrode is fixed to the first lead and the second electrode is fixed to the second lead.
